# EUROPEAN PATENT APPLICATION

(11) **EP 2 565 294 A1**
(43) Date of publication of application: **06.03.2013**
(21) Application number: 11179205.7
(22) Date of filing: 29.08.2011
(51) Int. Cl.: C23C 24/10, C23C 26/02, B22F 3/105, C30B 29/52, C30B 13/24, C30B 13/34, C30B 30/00

(54) **Manufacturing a component of single crystal or directionally solidified material**

(71) Applicant: SIEMENS AKTIENGESELLSCHAFT, 80333 München (DE)
(72) Inventor: Davis, Anthony, Bassingham, Lincoln, LN5 9EY (GB); Haje, Detlef, 02828 Görlitz (DE)

(57) **Abstract**

The present invention relates to a method for manufacturing a component (10) of a single crystal or a directionally solidified material, said component (10) being manufactured having a predefined shape (12), comprising at least the following steps: superimposing at least a powder layer (14) of a powder of a first material onto at least a surface (16) of a substrate (18) out of a second, single crystal or directionally solidified, material; transforming the powder layer (14) into a substrate layer (20) with a new surface (22) of the substrate (18) by altering at least a physical condition of the first material of the powder by applying energy to the powder layer (14); wherein said substrate layer (20) is becoming a part of the substrate (18); wherein the second, single crystal or directionally solidified, material of the substrate (18) has a grain orientation (24) and the material of the substrate layer (20) has a grain orientation (26); wherein the material of the substrate layer (20) adopts the same grain orientation (24) as the grain orientation (26) of the substrate (18) during the transforming process and wherein the steps are repeated till the component (10) has grown layer by layer into the predefined shape (12) and been manufactured thereby.

## Description

### Field of the Invention

The present invention relates to a method for manufacturing a component from a single crystal or a directionally solidified material. The present invention further relates to an apparatus intended for manufacturing a component out of a single crystal or a directionally solidified material.

### Background to the Invention

Modern gas turbines often operate at extremely high loads and temperatures. The effect of high loads and temperature on components of the turbine, like an aerofoil, an end wall, a turbine blade and/or stator vane, can be detrimental to the efficient operation of the turbine and can, in extreme circumstances, lead to distortion and possible failure of components or the blade or vane, respectively. In order to overcome this risk, the components of such turbines are built out of materials with a sufficient resistance against high loads and temperatures. Commonly used are components out of a single crystal or a directionally solidified material.

From US 5,275,228 a method is described to manufacture a turbine blade out of a single crystal material by a casting technique. In general, single crystal or directionally solidified material is expensive to produce and casting techniques have certain limitations on the geometry of the component.

It is a first objective of the present invention to provide a method for manufacturing a component of a single crystal or a directionally solidified material by which the above-mentioned shortcomings can be mitigated, and especially to provide a method where a manufacturing of a component with a homogeneous grain orientation is ensured.

It is a second objective of the invention to provide an advantageous apparatus for manufacturing a component out of a single crystal or directionally solidified material.

### Summary of the Invention

Accordingly, the present invention provides a method for manufacturing a component of a single crystal or a directionally solidified material, said component being manufactured having a predefined shape, comprising at least the following steps: superimposing at least a powder layer of a powder of a first material onto at least a surface of a substrate out of a second, single crystal or directionally solidified, material; transforming the powder layer into a substrate layer with a new surface of the substrate by altering at least a physical condition of the first material of the powder by applying energy to the powder layer; wherein said substrate layer is becoming a part of the substrate; wherein the second, single crystal or directionally solidified, material of the substrate has a grain orientation and the material of the substrate layer has a grain orientation; wherein the material of the substrate layer adopts the same grain orientation as the grain orientation of the substrate during the transforming process and wherein the steps are repeated till the component has grown layer by layer into the predefined shape and been manufactured thereby.

Due to the invention a component out of a single crystal or directionally solidified material could be manufactured easily and with low costs. Further, complex geometries or geometries with few limitations, especially for inner contours, could be produced, particularly, in comparison with conventional casting techniques.

In this context manufacturing should be understood as a manufacturing or production process in which a component is entirely newly created as a whole part. A repairing process should not be understood under manufacturing. A component is intended to mean any device, element, part or structure which could be manufactured out of a single crystal or a directionally solidified material and thus benefits from the properties of the single crystal or directionally solidified material, like resistance to high temperature, lack of grain boundaries, good mechanical, optical or electrical properties and/or low amount of impurities. The single crystal or directionally solidified material has an anisotropic material structure, wherein its material properties are a function of grain orientation. Under the phrase "being manufactured having a predefined shape" should be understood that beforehand of the manufacturing process a resulting shape of the component is defined and that the component is created during the manufacturing process according to this predefined shape. The first material should be a material, which is able to turn into a single crystal or a directionally solidified material during the transforming and/or manufacturing process. It may be advantageous if the first material is a single crystal or a directionally solidified material in its powdery state.

Moreover, the term "superimpose" is intended to mean "apply and/or deposit", the term "transform" "convert, alter and/or shape". A physical condition could be any condition feasible for a person skilled in the art, like magnetism, a temperature, a density, a state of aggregation and/or a grain orientation. In addition, a physical condition of the second, single crystal or directionally solidified, material of the substrate could be altered during the transforming process, preferably, the same physical condition as the physical condition of the first material could be altered. Further, more than one physical condition could be transformed. The phrase "applying of energy" should be understood as treatment with energy of any possible kind e. g. kinetic, chemical and/or thermal energy, like light and/or heat. The appliance of energy could be provided with any method feasible for a person skilled in the art which applies energy. The energy could be applied to the whole powder layer at the same time or to sections of the powder layer successively, wherein in case of the latter the sections e. g. could be positioned one after another in a working direction of a device for applying the energy. Moreover, it is possible, that regions of the powder layer are not treated and thus, maintain their original condition.

"Becoming a part of the substrate" is intended to mean that the substrate layer and the substrate are formed integrally with each other after the transforming, wherein formed integrally means that the substrate layer and the substrate could only be separate with loss of function for at least one of the structures. During the transforming process the substrate can function as a crystal nucleus.

Advantageously, the transforming of the powder layer comprises an altering of a state of aggregation of the powder or the first material of the powder, respectively. Due to this, the transformation of the powder layer could be easily performed. Preferably, the state of aggregation changes from a solid or powder state to a fluid state in the process of applying energy. The same could be true for at least a region of the substrate or the second, single crystal or directionally solidified, material of the substrate, respectively. After varying and/or removing the energy the state of aggregation of the first and/or second material could be further changed and preferably, from the fluid state back to a solid state or its original state of aggregation or physical condition.

A satisfactory manufacturing result could be obtained when the transforming of the powder layer comprises a method selected out of the group consisting of a sintering, a melting or a cladding and/or a method using as energy source a source selected out of the group consisting of a laser beam, an electron beam, an infra-red beam, a sonic beam or a microwave. All the possible methods could advantageously be deployed as a rapid prototyping method. Preferably, for the transforming of the powder layer a laser sintering is used.

Preferably, the application of energy is performed via an energetic beam, and especially, with an electron beam or a laser beam of a laser. By means of an energetic beam the energy could be applied efficiently and well controlled. Advantageously, the energetic beam has a power between 50 watt and 10 kilowatt, advantageously between 50 watt and 2500 watt, preferably of 200 watt. By using powerful lasers up to 10 kilowatt the process speed could be increased.

Further, the energetic beam has a diameter of between 0.025 mm and 0.5 mm, preferably, 0.05 to 0.1 mm. The laser could be any laser feasible for a person skilled in the art, like a carbon dioxide laser, a Nd:YAG laser, a diode laser or a fibre laser. Advantageously, a carbon-dioxide laser is used. The laser could be either a continuous laser, or a pulsed laser.

In a preferred embodiment an amount of energy of the energetic beam is used to control heating, melting and/or solidifying of at least the first material of the powder layer. As a result, the energetic beam can be adjusted according to the properties needed to optimize the manufacturing process and the properties of the resulting component. Advantageously, the amount of energy could also be used to control heating, melting and/or solidifying of at least the second, single crystal or directionally solidified, material.

In another preferred approach an energetic beam with a low power density is used. Such an energetic beam may be a low focus beam, wherein low focus means that the beam has a relatively big spot size; consequently the power per cm² is low. Preferably, the energetic beam is used as a low focus beam which has a power per area between 50 watt/cm² and 150 watt/cm², preferably of 75 watt/cm². A slow cooling process of the material will support a proper growth of crystals of the material. Hence, such a low focus beam may be used for a slow cooling process during the solidification process of the first and/or second material. Due to this, a substrate layer with a homogeneous grain orientation could be advantageously obtained. Moreover, the solidification of the material could be controlled easily by means of a low focus beam.

Alternatively or additionally, the low focus beam could be used for an in *situ* heat treatment process, especially for an ageing or an annealing process, and thus, for correction processes after the actual transforming of the powder layer into the substrate layer. A low focus beam could heat the substrate sufficiently to anneal and/or age the material. These processes improve the material properties advantageously by making it stronger. By means of the in *situ* heat treatment process e.g. impurities can be corrected immediately and efficiently after the solidification process.

To achieve a suitable heat balance of the process, a process temperature is maintained below a melting temperature of the first and or second material. This is advantageously performed by using a furnace. Generally, all devices which are able to maintain a constant heat environment could be used. A person skilled in the art would choose the suitable process temperature according to the used materials self-contained due to his knowledge. The process temperature is preferably maintained below a melting temperature of the material during the transforming process, preferably also during the solidification process. Due to the inventive embodiment, the thermal process properties e.g. during heating, melting and/or solidification of the material are solely dependent from the properties of the energy applied and/or the amount of energy of the energetic beam. Hence, the process is independent from outside temperatures. Additionally, the furnace could be used as an enclosed reaction chamber, in which other conditions of the process, like a pressure or an atmosphere, may be maintain as desired.

According to another preferred embodiment the grain orientation of at least the material of the substrate layer is detected in *situ* by means of a detection device. This could be deployed for control and/or correction purposes. Hence, the process and the composition of at least the new surface of the substrate can be monitored in real time during the transforming process. Due to this, it could be ensured, that incorrect formations or grain orientation are detected immediately. Moreover, no die has to be used like in conventional casting techniques, thus, saving time and costs. As detection device any device feasible for a person skilled in the art could be employed, like an X-Ray device, a video device, a microscope and preferably, a device working with the method of Laue diffraction or electron backscatter diffraction (EBSD).

In addition, it is provided that the method comprises a correction process, in which, when a grain orientation of a material of at least a section of the substrate layer is different from the grain orientation of the substrate, said section of the substrate layer is transformed by altering a physical condition of the material of the section by applying energy to correct the grain orientation of the section of the substrate layer in *situ.* Due to the correction step the inhomogeneous sections of a miss-formed substrate layer or out of specification section could be corrected immediately after its solidification and beforehand of a further superimposing of the next powder layer onto the new surface of the substrate. The correction step may comprise an in *situ* heat treatment process. Moreover, the difference in grain orientation of the section of the substrate layer and the substrate may be detected with the detection device in *situ.*

Preferably, the first material of the powder and the second, single crystal or directionally solidified, material of the substrate are the same single crystal or directionally solidified material, thus, providing a component with homogenous composition and properties. Advantageously, the material of the first and/or second material is a Ni-alloy, preferably one material selected out of the group consisting of CMSX-4, CMSX-10, CMSX-12, CM186DS, Mar M 247, Inconel DS6203 or SCA427. With the use of Ni-alloys a material with high resistance against high temperatures and/or corrosion could advantageously be employed. Generally, alternative superalloys are IN738, IN792 and IN939.

In an preferred embodiment a thickness of the powder layer of the powder of the first material is between 0.05 mm to 5 mm, preferably between 0.2 and 2 mm and especially advantageously 2 mm. Accordingly, the appliance of energy could be performed quickly and is sufficient to e.g. melt the powder of the powder layer. Moreover, the material of the first material of the powder layer could adopt the grain orientation of the substrate efficiently. A thickness of the substrate layer may be about 90% to 30%, advantageously 80% to 40% and preferably about 60% to 50% of the thickness of the powder layer. A thickness of 0.05 mm may be the minimum.

The inventive method is advantageously used for manufacturing of a blade and/or a vane out of a single crystal or directionally solidified material for a turbine assembly - particularly a gas turbine assembly -, wherein the component is the blade and/or the vane for the turbine assembly. Such manufactured blades and/or vanes may be less expensive as components manufactures according to conventional methods.

The invention further relates to a component out of a single crystal or a directionally solidified material manufactured with the inventive method.

The invention further provides an apparatus intended for manufacturing a component out of a single crystal or a directionally solidified material, said component being manufactured having a predefined shape, comprising a covering device equipped for superimposing at least a powder layer of a powder of a first material onto at least a surface of a substrate out of a second, single crystal or a directionally solidified, material; an energy device equipped for providing an energetic beam to initiate a transformation of the powder layer into a substrate layer and a furnace for maintaining a process temperature below a melting temperature of the first and/or second material. Preferably, the apparatus further comprises a detection device for detecting a grain orientation of the single crystal or directionally solidified material in *situ.*

The above-described characteristics, features and advantages of this invention and the manner in which they are achieved are clear and clearly understood in connection with the following description of exemplary embodiments which are explained in connection with the drawings.

### Brief Description of the Drawings

The present invention will be described with reference to drawings in which:
- FIG 1:: shows an apparatus for manufacturing a component out of a single crystal or a directionally solidified material at a start point of the manufacturing,
- FIG 2:: shows the apparatus from FIG 1 after a first substrate layer of the component is manufactured,
- FIG 3:: shows the apparatus and the component from FIG 1 at an end point of the manufacturing,
- FIG 4:: shows a predefined shape for the manufacturing of the component of FIG 1 and thus, the entirely manufactured component of FIG 2,
- FIG 5:: shows schematically a grain orientation of the substrate layer of FIG 2 out of a directionally solidified material,
- FIG 6:: shows schematically a grain orientation of a substrate layer out of an isotropic material and
- FIG 7:: shows a diagram of the temperature course during the manufacturing of the component with the apparatus from FIG 1.

### Detailed Description of the Illustrated Embodiment

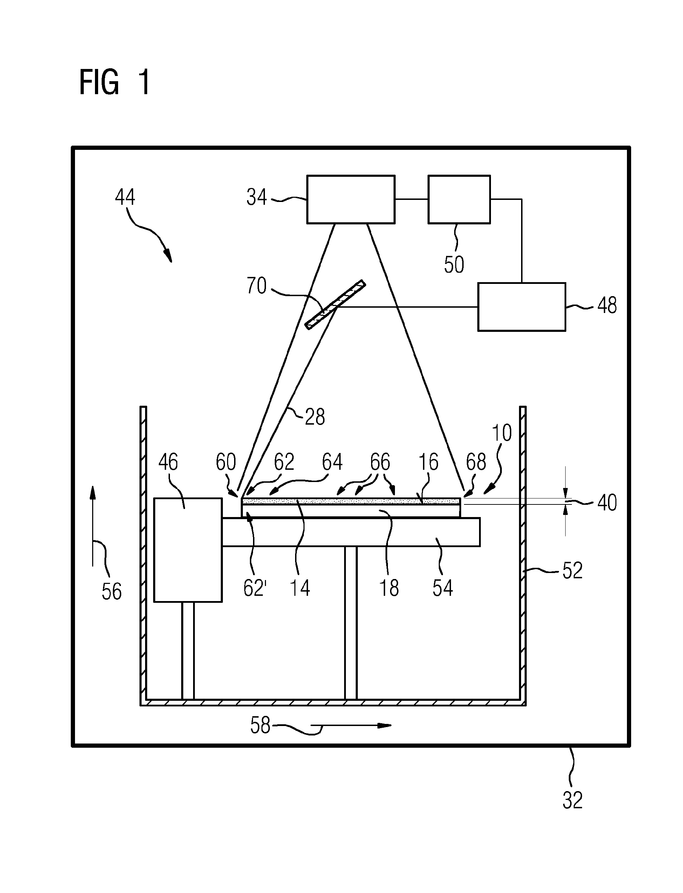

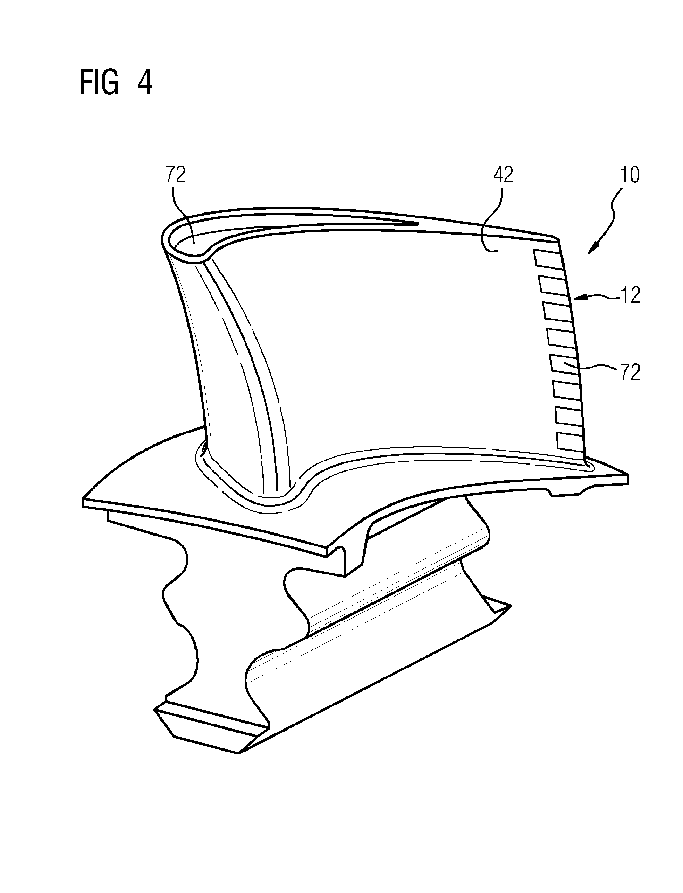

FIG 1 shows an apparatus 44 intended for manufacturing a component 10 out of a single crystal or a directionally solidified material, which is a Ni-alloy, for example CMSX-4. The component 10 is a blade 42 for a turbine assembly as it is shown in FIG 4. The component 10 will be manufactured having a predefined shape 12 (see FIG 4). Therefore, beforehand of the manufacturing process a resulting shape 12 of the component 10 is defined by an operator and the data referring to the shape 12 are lodged or saved in a CPU 50 of the apparatus 44. During the manufacturing process the component 10 is than created according to the predefined shape 12.

The apparatus 44 comprises a cavity 52 in which the manufacturing process takes place. Moreover, the apparatus 44 comprises a covering device 46, which is equipped for superimposing a powder layer 14 of a powder of a first material, which is a single crystal or a directionally solidified material, wherein this material is also CMSX-4. Further, the apparatus 44 comprises an energy device 48, embodied as for example a carbon dioxide laser, equipped for providing an energetic beam 28. Additionally, the apparatus 44 comprises a detection device 34, embodied as LAUE Diffraction device, to monitor in *situ* the material formed by the manufacturing process. The energy device 48 and the detection device 34 are arranged outside of the cavity 52.

At the beginning of the manufacturing process a substrate 18 is placed at a platform 54 arranged at a bottom of the cavity 52. The substrate 18 is build out of a second, single crystal or a directionally solidified, material, wherein this material is also CMSX-4. Thus, the first material of the powder and the second, single crystal or directionally solidified, material of the substrate 18 are the same single crystal or directionally solidified material. In the following description the first material and the second, single crystal or directionally solidified, material are named first and second material for better readability.

After placement of the substrate 18, a powder layer 14 of the powder of a first material is superimposed onto a surface 16 of the substrate 18 by means of the covering device 46. The powder layer 14 of the powder of the first material is for example applied in a thickness 40 of about 2 mm (not shown according to the proper dimension).

In a next step energy is applied to the powder layer 14 with the energetic beam 28 or laser beam of the energy device 48 by means of a laser sintering. The process starts at an end 60 of the powder layer 14 by heating a first region 62 of the powder layer 14 with the energetic beam 28, which has a power of about 200 watt. Due to the heat the first material of the region 62 of the powder layer 14 melts. Additionally, the energetic beam 28 heats and melts, respectively, the second material of a first region 62' of the substrate 18. The molten first and partially molten second material build a melt pool. Hence, the appliance of energy alters a physical condition, namely a state of aggregation from solid to fluid, of the first and second material of the powder and the substrate 18.

After melting of the powder and the substrate 18 in the first region 62 the energetic beam 28 is moved successively in a working direction of the energy device 48, which is the axial direction 58, to a second region 64 and following regions 66 (only shown schematically) of the powder layer 14 and the substrate 18 till an end 68 of the powder layer 14 or the substrate 18 is reached. This is mediated by a mirror 70, which is moved in axial direction 58. It is also possible that the energy is not applied to all regions of the powder layer 14 in axial direction 58 e.g. to build holes 72 in the component 10 according to the shape 12 (see FIG 4).

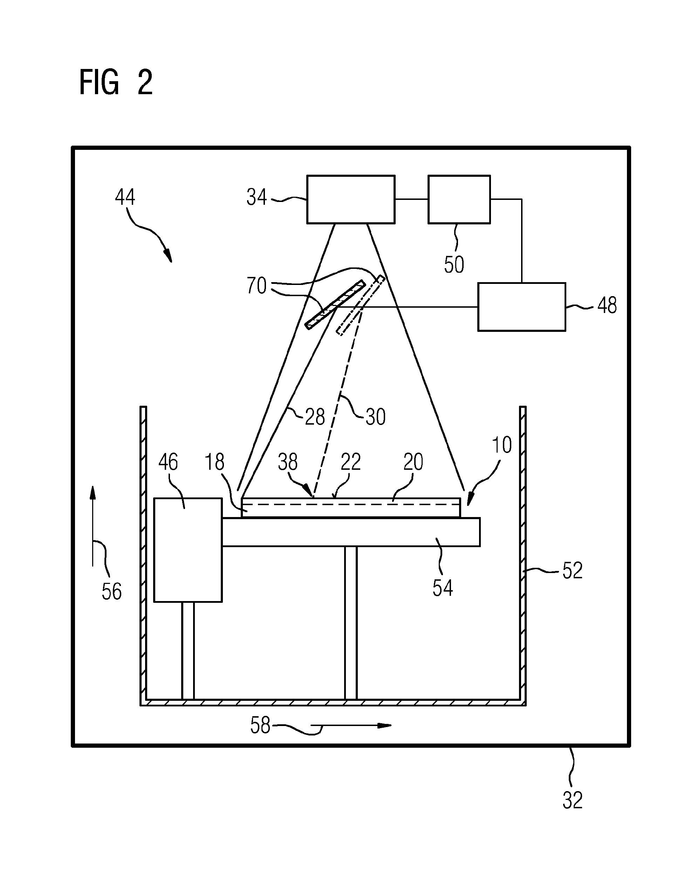

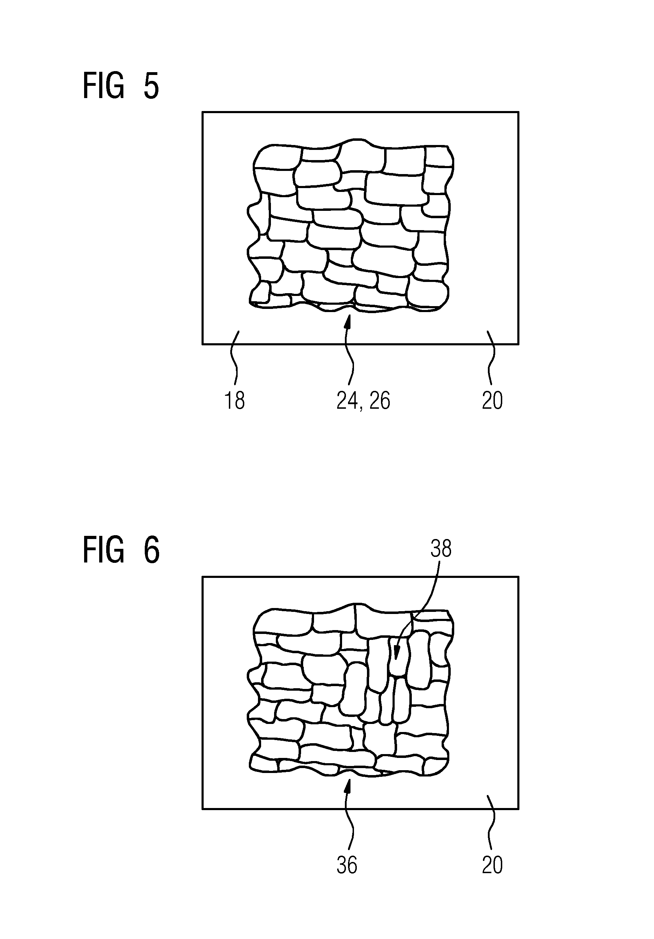

After removing the energy of the energetic beam 28 the melt pool cools down, the material solidifies and the state of aggregation changes from the fluid state back to a solid state. Due to the heating, melting, cooling and solidifying of the powder layer 14 it is transformed into a substrate layer 20 with a new surface 22 of the substrate 18, as could be seen in FIG 2, wherein the substrate layer 20 is marked with a broken line. The substrate layer 20 has become a part of the substrate 18 and thus, is integrally formed with the substrate 18. The second material of the substrate 18 has a grain orientation 24 and the material of the substrate layer 20 has a grain orientation 26 (see FIG 5 shown exemplary for a directionally solidified material). During the solidification and transforming process the substrate 18 acts as a crystal nucleus and the material of the substrate layer 20 adopts the same grain orientation 24 as the grain orientation 26 of the substrate 18 (see FIG 5).

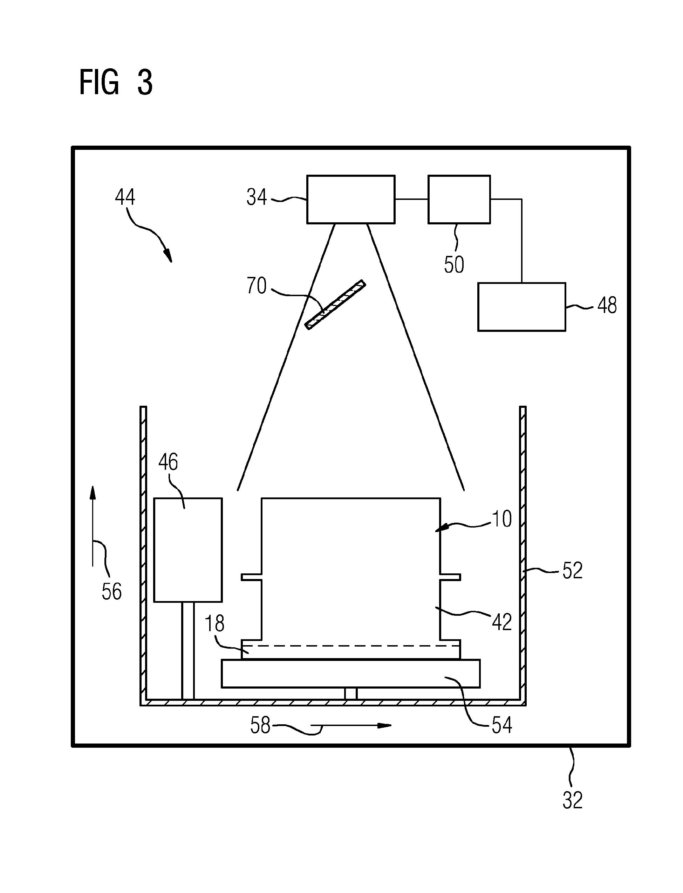

When the cooling and solidification is completed the substrate 18 is moved against the vertical direction 56 with the moveable platform 54 to compensate for the growth of the component 10. Then a second powder layer 14 is applied onto the new surface 22 of the substrate layer 20 of the substrate 18 and the transforming process is repeated (not shown). The steps of superimposing and transforming are repeated till the component 10 has grown layer by layer into the predefined shape 12 and the component 10 has been manufactured thereby (see FIG 3 and 4, in FIG 3 the component 10 is only shown schematically).

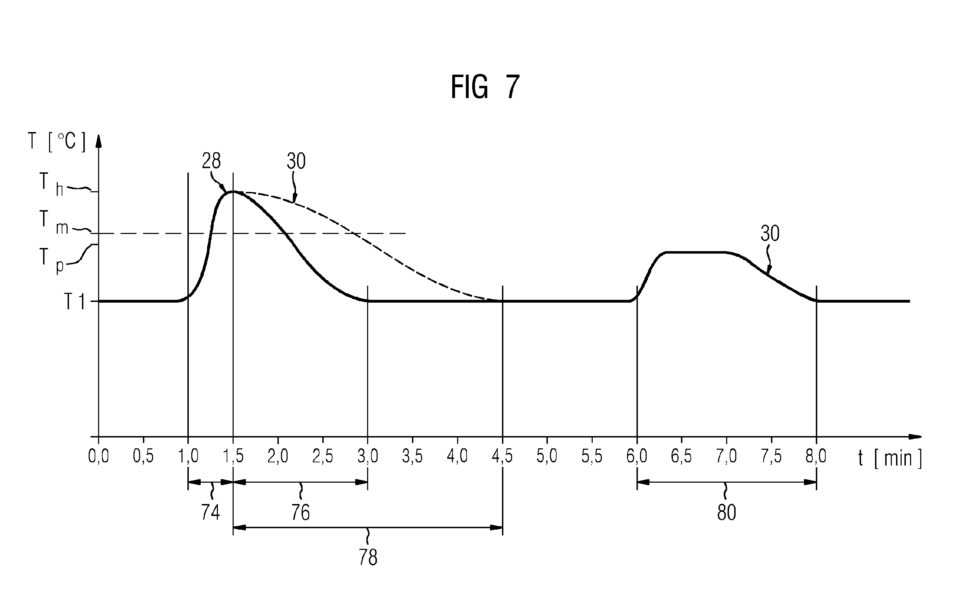

In FIG 7 a diagram of the temperature course of the powder layer 14 and the resulting substrate layer 20 during the manufacturing of one substrate layer 20 is shown. On the x-axis the time (t) in [min] is plotted and on the y-axis the temperature (T) in [°C]. At the beginning (t=0) and during the superimposing of the powder layer 14 (t=0-1) the cavity 52 is held at room temperature T1. Hence, the powder layer 14 has also room temperature T1. After the application of energy has started the temperature T of the powder layer 14 increases rapidly in a heating cycle 74 (t=1-1.5) to a maximum temperature Tₕ. At the maximum temperature Tₕ the powder layer 14 and region 62' of the substrate 18 has built the melt pool and the application of energy is stopped. In a following uncontrolled cooling cycle 76 (t=1.5-3, unbroken line) the melt pool cools down to room temperature T1 and the material of the substrate layer 20 solidifies.

To control heating, melting and solidifying of the first material of the powder layer 14 an amount of energy of the energetic beam 28 could be used. For example, a slow cooling process of the material of the melt pool will support a proper growth of crystals of the material. Such a slow controlled cooling during the solidification process could be provided by using the energetic beam 28 as a low focus beam 30 which has for example a power per area of about 75 watt/cm². Such a slow controlled cooling cycle 78 (t=1.5-4.5) is shown in FIG 6 in a broken line.

Moreover, the apparatus 44 could be placed into a furnace 32 for maintaining a process temperature Tp below a melting temperature Tₘ of the first and second material to control the thermal properties of the manufacturing solely via the energy of the energetic beam 28.

During the manufacturing process and especially after the substrate layer 20 is solidified and build, the grain orientation 24, 36 of the material of the substrate layer 20 is detected in *situ* by means of the detection device 34. As shown in FIG 6, it could occur that the substrate layer 20 has a section 38 with impurities and the grain orientation 36 of the material of this section 38 of the substrate layer 20 is isotropic. Thus, it has not the desired structure of a single crystal or directionally solidified material as shown in FIG 6 exemplary for a directionally solidified material. Hence, when the grain orientation 36 of the material of the section 38 of the substrate layer 20 is different from the grain orientation 26 of the substrate 18, as it is detected from the detection device 34, a correction process is performed. There the section 38 of the substrate layer 20 is transformed by altering a physical condition of the material of the section 38 by applying energy to correct the grain orientation 36 of the section 38 of the substrate layer 20 in *situ*.

The correction process may be performed as an optional heating cycle 80 (t=6-8) as could be seen in FIG 7. Again a low focus beam 30 could be used to execute an in *situ* heat treatment process, especially for an ageing or an annealing process (see FIG 2). In these cases the low focus beam 30 could exemplary have a power per area of about 75 watt/cm².

According to the embodiments it is advantageous that the molten metal may take crystal orientation of the substrate.

Although the invention is illustrated and described in detail by the preferred embodiments, the invention is not limited by the examples disclosed, and other variations can be derived therefrom by a person skilled in the art without departing from the scope of the invention.

## Claims

1. A method for manufacturing a component (10) of a single crystal or a directionally solidified material, said component (10) being manufactured having a predefined shape (12), comprising at least the following steps:
- superimposing at least a powder layer (14) of a powder of a first material onto at least a surface (16) of a substrate (18) out of a second, single crystal or directionally solidified, material;
- transforming the powder layer (14) into a substrate layer (20) with a new surface (22) of the substrate (18) by altering at least a physical condition of the first material of the powder by applying energy to the powder layer (14);
wherein said substrate layer (20) is becoming a part of the substrate (18);
wherein the second, single crystal or directionally solidified, material of the substrate (18) has a grain orientation (24) and the material of the substrate layer (20) has a grain orientation (26);
wherein the material of the substrate layer (20) adopts the same grain orientation (24)as the grain orientation (26) of the substrate (18) during the transforming process and
wherein the steps are repeated till the component (10) has grown layer by layer into the predefined shape (12) and been manufactured thereby.

2. The method according to Claim 1, wherein the transforming of the powder layer (14) comprises an altering of a state of aggregation of the powder.

3. The method according to Claim 1 or Claim 2, wherein the transforming of the powder layer (14) comprises a method selected out of the group consisting of a sintering, a melting or a cladding and/or a method using as energy source a source selected out of the group consisting of a laser beam, an electron beam, an infra-red beam, a sonic beam or a microwave.

4. The method according to any of the preceding claims, wherein the application of energy is performed via an energetic beam (28).

5. The method according to Claim 4, wherein the energetic beam (28) has a power between 50 watt and 2500 watt, preferably of 200 watt.

6. The method according to any of the preceding Claims 4 and 5, wherein an amount of energy of the energetic beam (28) is used to control heating, melting and/or solidifying of at least the first material of the powder layer (14).

7. The method according to any of the preceding Claims 4 and 5, wherein the energetic beam (28) is used as a low focus beam (30) which has a power per area between 50 watt/cm² and 150 watt/cm², preferably of 75 watt/cm².

8. The method according to any preceding claim, wherein a process temperature (Tp) is maintained below a melting temperature (Tₘ) of at least the first material by using a furnace (32).

9. The method according to any of the preceding claims, wherein the grain orientation (24, 36) of at least the material of the substrate layer (20) is detected in situ by means of a detection device (34).

10. The method according to any of the preceding claims, **characterized by** a correction process, in which, when a grain orientation (36) of a material of at least a section (38) of the substrate layer (20) is different from the grain orientation (26) of the substrate (18), said section (38) of the substrate layer (20) is transformed by altering a physical condition of the material of the section (38) by applying energy to correct the grain orientation (36) of the section (38) of the substrate layer (20) in situ.

11. The method according to any of the preceding claims, wherein the first material of the powder and the second, single crystal or directionally solidified, material of the substrate (18) are the same single crystal or directionally solidified material.

12. The method according to any of the preceding claims, wherein the material of the first material and/or the second, single crystal or directionally solidified, material is a Ni-alloy, preferably one material selected out of the group consisting of CMSX-4, CMSX-10, CMSX-12, CM186DS, Inconel DS6203, Mar M 247 or SCA427.

13. The method according to any of the preceding claims, wherein a thickness (40) of the powder layer (14) of the powder of the first material is between 0.05 mm to 5 mm, preferably 2 mm.

14. The method according to any of the preceding claims, used for manufacturing of a blade (42) and/or a vane out of a single crystal or directionally solidified material for a turbine assembly, wherein the component (10) is the blade (42) and/or the vane for the turbine assembly.

15. An apparatus (44) intended for manufacturing a component (10) out of a single crystal or a directionally solidified material, said component (10) being manufactured having a predefined shape (12), comprising a covering device (46) equipped for superimposing at least a powder layer (14) of a powder of a first material onto at least a surface (16) of a substrate (18) out of a second, single crystal or a directionally solidified, material, an energy device (48) equipped for providing an energetic beam (28) to initiate a transformation of the powder layer (14) into a substrate layer (20) and a furnace (32) for maintaining a process temperature (Tp) below a melting temperature (Tₘ) of the first material and/or the second, single crystal or directionally, solidified material.
